# FASCICULE DE BREVET EUROPEEN

(11) **EP 2 850 562 B1**
(45) Date de publication et mention de la délivrance du brevet: **28.12.2016**
(21) Numéro de dépôt: 13725313.4
(22) Date de dépôt: 16.05.2013
(51) Int. Cl.: H05K 3/30, H05K 3/36, G06K 19/077

(54) **PROCEDE DE FABRICATION D'UNE CARTE ELECTRONIQUE AYANT UN CONNECTEUR EXTERNE**
HERSTELLUNGSVERFAHREN EINER ELEKTRONISCHEN KARTE MIT EXTERNEM ANSCHLUSS
METHOD FOR MANUFACTURING AN ELECTRONIC CARD WITH AN EXTERNAL CONNECTOR

(30) Priorité: 16.05.2012 EP 12168338
(43) Date de publication de la demande: 25.03.2015
(73) Titulaire: Nagravision S.A., 1033 Cheseaux-sur-Lausanne (CH)
(72) Inventeur: DROZ, François, CH-2035 Corcelles (CH)
(74) Mandataire: Surmely, Gérard
(86) Numéro de dépôt international: PCT/EP2013/060167
(87) Numéro de publication internationale: WO 2013/171314

(56) Documents cités:
- EP-A1- 2 296 109
- WO-A2-97/34247
- DE-A1- 19 732 645
- DE-A1- 19 809 073

## Description

### Domaine technique

La présente invention concerne le domaine des cartes électroniques, notamment du type bancaire, comprenant une unité électronique et/ou une antenne incorporée(s) dans le corps de cette carte et un connecteur externe agencé dans un logement de ce corps de carte, ce connecteur présentant une pluralité de plages de contact externes agencées sur une face externe d'un support isolant formant ce connecteur. L'unité électronique et/ou une antenne est/sont reliée(s) électriquement à une pluralité de plages de contact métalliques internes du corps de carte qui sont agencées sous le connecteur externe et qui sont respectivement reliées électriquement à au moins un sous-ensemble de la pluralité de plages de contact externes et/ou à des plages de contact associées à une deuxième unité électronique, agencée sur la face interne du connecteur et située dans ledit logement, par des jonctions électriques comprenant chacune une soudure du côté de la plage de contact métallique interne correspondante de manière à assurer un contact soudé à celle-ci.

### Arrière-plan technologique

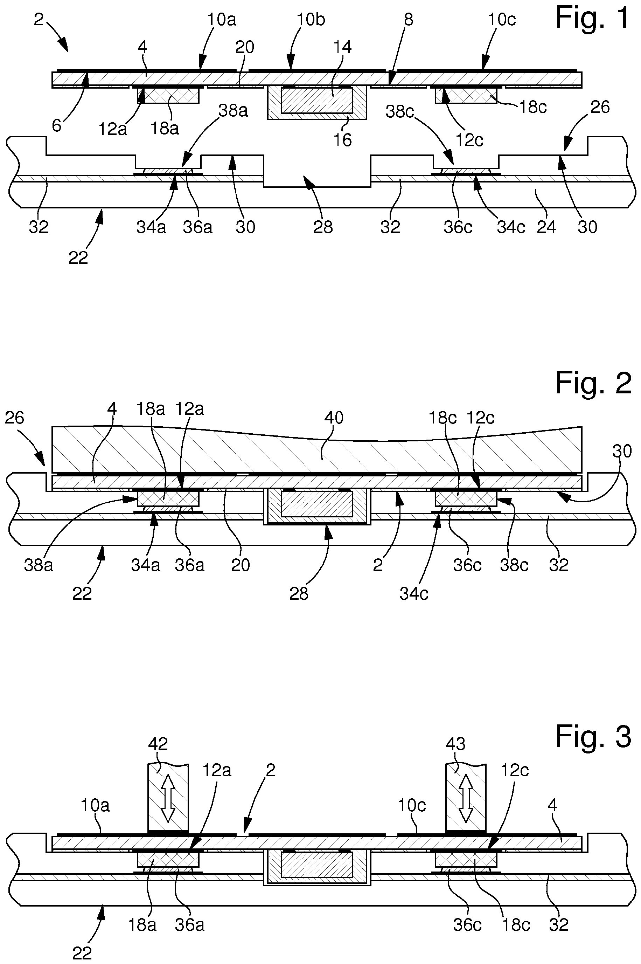

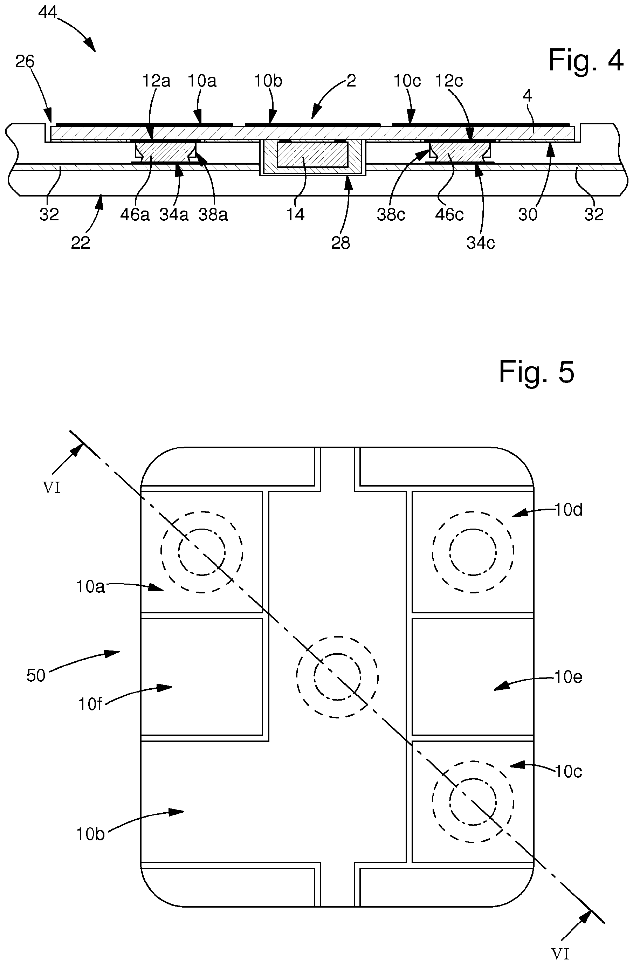

Il est connu du document DE 197 32 645 une carte électronique dans laquelle est incorporée une antenne ainsi qu'un procédé de fabrication d'une telle carte. Dans un mode de mise en oeuvre particulier de ce procédé représenté en partie aux figures 3A-3C et 4A-4C, l'antenne est formée par une bobine plane avec un fil métallique de section circulaire. En général, le diamètre d'un tel fil est très petit (100 à 150 microns). De manière à contacter les deux extrémités de l'antenne à une unité électronique, il est prévu premièrement de réaliser deux trous dans le corps de carte jusqu'à une profondeur correspondant à un plan médian de ces deux extrémités, ces deux trous présentant un diamètre sensiblement égal à celui du fil d'antenne. Ensuite, les deux trous sont remplis d'une colle conductrice ou d'une brasure. La manière dont la colle conductrice ou la brasure sont apportés dans les deux trous de petit diamètre n'est nullement exposée dans ce document DE 197 32 645. Or cette étape du procédé n'est pas évidente. Comment peut-on introduire de la colle ou de la brasure dans de si petits trous dans une production industrielle ? Premièrement il y a une question de précision du positionnement d'une buse ou aiguille servant à apporter la colle ou la brasure. Ensuite, comment permettre à l'air présent initialement dans les trous de s'échapper lors de l'introduction de la colle ou de la brasure ? La réponse à cette question est importante car il faut assurer une connexion électrique par ces trous. L'homme du métier ne trouve pas de réponse dans le document en question et de fait la réponse n'est pas évidente car l'air est généralement emprisonné par la colle ou la brasure introduite par l'ouverture. Il se forme donc une sorte de bouchon emprisonnant de l'air au fond de chaque trou et le reste de la matière apportée s'étale alors sur la surface plane à la périphérie des trous. On comprend qu'une telle situation est particulièrement néfaste lorsque les trous sont proches à cause du risque élevé de court-circuit. Ainsi l'homme du métier jugera le mode de réalisation d'une carte électronique selon les figures 3A-3C et 4A-4C du document DE 197 32 645 comme étant très difficile à mettre en oeuvre, voire pratiquement impossible.

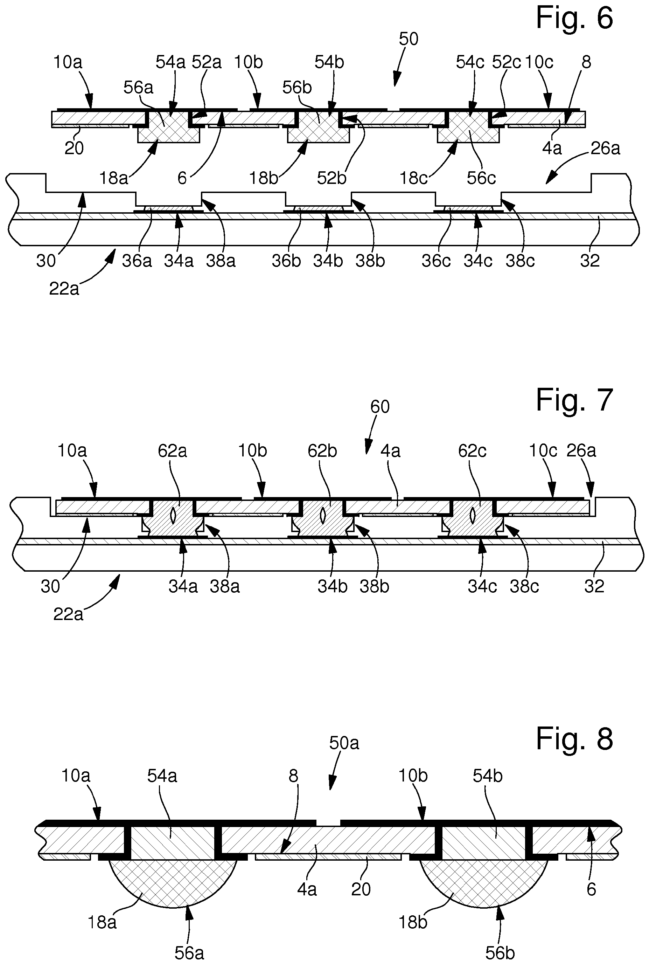

Il est connu du document WO 97/34247 une carte électronique où la brasure prévue entre les plages de contact respectives pour former les connexions électriques est incorporée dans un film de colle. La brasure est incorporée notamment dans des ouvertures effectuées dans ce film de colle (voir figures 8 et 10), lequel est ensuite apporté sur un épaulement agencé dans l'évidement prévu pour un module électronique de manière que les ouvertures remplies de brasures sont alignées sur des plages de contact internes apparaissant à la surface de l'épaulement. Le module électronique est agencé de manière que la brasure soit également en regard de plages de contact agencées sur la face interne d'un support isolant de ce module. Finalement, la colle est activée et la brasure est fondue par un apport de chaleur au travers du support isolant. On remarquera que l'apport de brasure dans des ouvertures d'un film de colle avant que celui-ci soit assemblé au module électronique ou au corps de carte pose des problèmes de fabrication, car il n'est pas évident d'assurer le maintien de la brasure dans les ouvertures du film de colle jusqu'à l'assemblage du module électronique avec le corps de carte. Ainsi, dans une variante, il est prévu d'introduire des particules conductrices dans un film de colle dans les zones prévues pour les soudures.

### Résumé de l'invention

La présente invention a pour but de palier les inconvénients de l'art antérieur susmentionné et de proposer premièrement un procédé de fabrication de cartes électroniques ayant chacune un connecteur externe avec des premières plages de contact soudées de manière fiable à des deuxièmes plages de contact d'un module électronique incorporé dans le corps de carte. L'invention a pour but particulier d'assurer la fiabilité des connexions électriques entre les premières et deuxièmes plages de contact, en particulier lorsque leur nombre est relativement élevé et notamment supérieur à quatre, et de dissocier dans une large mesure l'épaisseur du support isolant du connecteur externe et le positionnement desdites deuxièmes plages de contact dans le corps de carte et donc, le cas échéant, du support interne sur lequel elles sont agencées.

A cet effet, la présente invention a pour objet un procédé de fabrication d'une carte électronique formée par :
- un connecteur externe comprenant un support isolant, définissant une face externe et une face interne opposées l'une à l'autre, et une pluralité de plages de contact métalliques externes qui sont agencées sur la face externe de ce support isolant;
- un corps de carte présentant un logement pour le connecteur externe;
- une unité électronique et/ou une antenne incorporée(s) dans le corps de carte et reliée(s) électriquement à ou présentant une pluralité de plages métalliques internes qui sont agencées sous le logement.

Ce procédé de fabrication comprend une étape d'usinage de cavités individuelles dans le corps de carte jusqu'à ce que les plages métalliques internes soient atteintes ou jusqu'à ce que des parties métalliques, agencées sur ces plages métalliques internes et en contact électrique avec celles-ci, soient atteintes, ces parties métalliques ou les plages métalliques internes pouvant être partiellement usinées, les cavités individuelles ayant une section transversale dont au moins une dimension est supérieure à 0,5 mm (500 µm). Le procédé de fabrication comprend en outre les étapes suivantes :
- formation du connecteur externe avec une pluralité de protubérances métalliques situées du côté de la face interne du support isolant et respectivement reliées électriquement à au moins un sous-ensemble de la pluralité de plages de contact métalliques externes et/ou à des plages de contact associées à une deuxième unité électronique qui est agencée sur la face interne du support isolant et destinée à être située dans le logement du corps de carte, ces protubérances métalliques étant agencées de manière à être respectivement en face des cavités individuelles lors du placement du connecteur externe dans le logement et configurées pour pouvoir être introduites dans ces cavités individuelles ;
- suite à la formation du connecteur externe et à l'usinage de cavités individuelles dans le corps de carte, placement de ce connecteur externe dans le logement du corps de carte, les protubérances métalliques étant alors introduites dans les cavités individuelles respectives de manière à les remplir au moins partiellement, le volume initial de chaque protubérance étant prévu de manière que le volume de cette protubérance, une fois le connecteur en place dans son logement, soit sensiblement égal ou inférieur au volume de la cavité individuelle correspondante ;
- apport d'énergie transmise au moins partiellement aux protubérances métalliques pour effectuer un soudage au moins du côté des plages métalliques internes et former des contacts soudés entre celles-ci et le connecteur externe, des jonctions électriques étant ainsi obtenues entre les plages métalliques internes et le au moins un sous-ensemble de la pluralité de plages de contact métalliques externes et/ou les plages de contact associées à la deuxième unité électronique.

Selon un mode de mise en oeuvre préféré du procédé de fabrication selon l'invention, le support isolant présente une pluralité d'ouvertures entre sa face externe et sa face interne, les ouvertures de cette pluralité d'ouvertures étant respectivement fermées par les plages externes du au moins un sous-ensemble de la pluralité de plages de contact métalliques externes du côté de la face externe du support isolant. Les ouvertures sont au moins partiellement remplies par des parties métalliques respectives qui forment avec les protubérances métalliques respectives qui les surmontent ou les prolongent, suite à l'apport d'énergie qui est fourni aux protubérances métalliques respectives et également aux parties métalliques, des ponts de jonction métalliques entre les surfaces arrières des plages externes respectives et les plages internes correspondantes, ces ponts de jonction métalliques comprenant chacun une soudure du côté de la surface arrière de la plage externe correspondante qui assure un contact soudé à cette dernière.

Selon une variante du mode de mise en oeuvre préféré, les ponts de jonction métalliques sont chacun constitués par une brasure qui est fondue par l'apport d'énergie de manière à former une seule et même soudure entre une plage interne et la surface arrière de la plage externe correspondante.

D'autres caractéristiques particulières de l'invention seront exposées ci-après dans la description détaillée de l'invention.

### Brève description des dessins

L'invention sera décrite ci-après à l'aide de dessins annexés, donnés à titre d'exemples nullement limitatifs, dans lesquels :
- Les Figures 1 à 3 montrent trois étapes successives d'un mode de mise en oeuvre du procédé de fabrication selon l'invention d'une carte électronique avec un connecteur externe;
- La Figure 4 est une vue partielle en coupe d'un premier mode de réalisation d'une carte électronique avec un connecteur externe selon l'invention;
- La Figure 5 est une vue de dessus d'un mode de réalisation préféré d'un connecteur externe selon l'invention;
- La Figure 6 est une vue en coupe montrant le connecteur externe de la Figure 5 et partiellement le corps de carte dans la région du logement prévu pour le connecteur, avant leur assemblage;
- La Figure 7 est une vue partielle en coupe d'un deuxième mode de réalisation préféré d'une carte électronique avec un connecteur externe selon l'invention;
- La Figure 8 est une vue partielle en coupe d'une variante de réalisation du connecteur représenté à la Figure 6 ; et
- La Figure 9 montre schématiquement un mode de fabrication d'une pluralité de connecteurs externes selon l'invention.

### Description détaillée de l'invention

On décrira ci-après à l'aide des Figures 1 à 4 le procédé de fabrication selon l'invention d'une carte électronique et la carte résultante selon un premier mode de réalisation.

La carte électronique fabriquée comprend :
- un connecteur externe 2 comprenant un support isolant 4 et une pluralité de plages de contact métalliques externes 10a, 10b, 10c qui sont agencées sur la face externe 6 de ce support isolant;
- un corps de carte 22 présentant un logement 26 pour le connecteur externe 2;
- une unité électronique et/ou une antenne (non représentées sur les Figures) qui est/sont incorporée(s) dans le corps de carte 22 et reliée(s) électriquement à une pluralité de plages de contact métalliques internes 34a, 34c situées dans le corps de carte en dessous du logement 26, c'est-à-dire sous la surface générale définissant le fond de ce logement, laquelle est formée par l'évidement 28 et la surface horizontale 30 entourant cet évidement.

Le procédé de fabrication comprend généralement les étapes suivantes :
- usinage de cavités individuelles 38a et 38c dans le corps de carte 22 au fond du logement 26, en regard des plages internes 34a, 34c de la pluralité de plages de contact métalliques internes, jusqu'à une profondeur donnée ou jusqu'à ce que ces plages internes soient atteintes ou jusqu'à ce que des parties métalliques 36a, 36c agencées sur ces plages internes et en contact électrique avec celles-ci soient tronquées et définissent alors des surfaces de contact au fond des cavités individuelles;
- formation du connecteur externe 2 avec une pluralité de protubérances métalliques 18a, 18c situées du côté de la face interne 8 du support isolant 4 et respectivement reliées électriquement à au moins un sous-ensemble de la pluralité de plages de contact métalliques externes et/ou à des plages de contact associées à une deuxième unité électronique 14 qui est agencée sur la face interne du support isolant et destinée à être située dans le logement 26, ces protubérances métalliques 18a, 18c étant agencées de manière à être respectivement en face des cavités individuelles 38a, 38c lors du placement du connecteur externe dans le logement (situation Figure 1);
- suite à ladite formation du connecteur externe et à l'usinage des cavités individuelles dans le corps de carte, placement de ce connecteur externe dans le logement 26 du corps de carte, les protubérances métalliques étant alors introduites dans les cavités individuelles respectives (situation Figure 2);
- apport d'énergie transmise au moins partiellement aux protubérances métalliques 18a, 18c (Figure 3) de manière à effectuer un soudage au moins du côté des plages internes 34a, 34c pour obtenir des contacts soudés à celles-ci et à former des jonctions électriques entre les plages internes et ledit au moins un sous-ensemble de la pluralité de plages de contact métalliques externes et/ou lesdites plages de contact associées à la deuxième unité électronique 14.

On remarquera que les liaisons électriques entre les protubérances métalliques et au moins un sous-ensemble de la pluralité de plages de contact métalliques externes et/ou des plages de contact associées à l'unité électronique 14 n'ont pas été représentées sur les Figures 1 à 4. Les connexions électriques entre des protubérances et des contacts de l'unité électroniques peuvent être réalisés classiquement par des pistes conductrices déposées sur la face interne 8 du support isolant 4. Les plages externes sont connectées électriquement à des protubérances et/ou des contacts de l'unité électronique 14 par des vias typiques, par des pistes qui descendent la paroi latérale du support isolant 4 ou par tout autre moyen connu de la personne du métier. L'unité électronique 14 est classiquement protégée par une résine 16 solidifiée qui la recouvre.

Dans une variante préférée, les protubérances métalliques 18a, 18c sont constituées par une brasure déposée de préférence sous forme de pâte. Dans une autre variante où ces protubérances sont formées par des pastilles en métal rigide (par exemple en cuivre), un soudage entre ces pastilles et les plages internes 34a, 34c est réalisé grâce à la présence des parties métalliques 36a, 36c constituées par une brasure, par exemple de l'étain. D'autres brasures à base d'argent ou d'or peuvent être notamment prévues.

Le procédé de fabrication est exposé ici dans le cas de la fabrication d'un premier mode de réalisation d'une carte électronique 44 selon l'invention, plus particulièrement avec un premier mode de réalisation du connecteur externe. Selon ce premier mode de réalisation, une pluralité de plages de contact intermédiaires 12a, 12c sont agencées sur la face interne 8 du connecteur externe 2 et reliées électriquement audit au moins un sous-ensemble de la pluralité de plages de contact métalliques externes et/ou aux plages de contact associées à l'unité électronique 14. Ces plages de contact intermédiaires sont respectivement situées en face des plages internes 34a, 34c et le matériau métallique constituant les protubérances est une brasure qui forme, suite à l'apport d'énergie mentionné précédemment, une soudure 46a, 46c entre chacune desdites plages internes et une plage de contact intermédiaire correspondante parmi les plages de contact intermédiaires 12a, 12c, comme représenté à la Figure 4.

Dans une première variante, la brasure constituant lesdites protubérances 18a, 18c est apportée sous forme de pâte et est ensuite durcie avant le placement du connecteur externe dans le logement 26. Dans une autre variante, la brasure est apportée dans un état de métal en fusion (état liquide) via une buse chauffante. Dans ce dernier cas, on obtient après durcissement du métal fondu une protubérance en métal plein et solide. Dans les deux variantes mentionnées, il est possible de prévoir une mise en forme des protubérances par un outil de mise en forme apporté sur les protubérances en exerçant sur celles-ci une pression de mise en forme.

De préférence, les protubérances ont des dimensions initiales prévues de manière que, suite au placement du connecteur externe dans le logement, ces protubérances remplissent en majeure partie mais pas totalement les cavités individuelles respectives. Ceci permet de s'assurer qu'aucune brasure ne sortent des cavités individuelles et ne s'étendent sur la surface 30 du fond du logement 26 ; ce qui pourrait sinon provoquer des courts-circuits. Aux Figures 2 et 3, la brasure constituant les protubérances remplit entièrement les cavités 38a, 38c. Ceci correspond à une autre variante où le dosage lors de la formation des protubérances est ajusté précisément. On notera que cette situation peut aussi résulter de protubérances ayant initialement une épaisseur légèrement supérieur à la profondeur des cavités individuelles. Dans un premier cas, la brasure sous forme de pâte séchée peut être écrasée lors du placement du connecteur externe dans le logement 26, permettant de densifier l'apport de brasure. Dans un second cas, on prévoit les dimensions des protubérances, dans un plan général parallèle au support 4, inférieures à celles des cavités individuelles 38a, 38c (dans le cas de cavités cylindriques, le diamètre de celles-ci est supérieur au diamètre des protubérances correspondantes).

Grâce aux caractéristiques de l'invention, il est ainsi possible d'avoir un relativement grand nombre de plages de contact internes reliées à autant de plages de contact du connecteur externe et de pouvoir disposer les cavités individuelles selon l'invention proches l'une de l'autre sans risquer de courts-circuits. Ensuite, il y a une indépendance entre l'épaisseur du support isolant, donc du niveau / de la profondeur de la surface 30 définissant le fond du logement 26, et le niveau où sont agencées les plages de contact internes 34a, 34c dans l'épaisseur du corps de carte 22. Finalement, l'invention permet un apport relativement important de brasure par protubérance pour effectuer un soudage et obtenir ainsi des jonctions électriques soudées entre les plages internes et les plages de contact correspondantes du connecteur externe (les plages intermédiaires 12a, 12c dans le cas du premier mode de réalisation d'une carte de la Figure 4).

Selon une variante particulière, représentée sur les Figures, il est prévu de déposer un film de colle 20 sur la face interne 8 dudit support isolant 4. Ce film de colle sert à coller le connecteur externe contre le fond (surface 30) du logement 26 et il présente des ouvertures desquelles sortent les protubérances métalliques 18a, 18c. On utilise pour fixer le connecteur externe dans son logement une presse 40, au travers de laquelle de la chaleur peut être apportée pour fondre ou activer le film de colle et permettre ainsi le collage du connecteur externe au corps de carte. On remarquera que l'assemblage par la colle est un moyen de fixation supplémentaire aux jonctions électriques soudées décrites précédemment.

Selon une variante préférée du procédé de fabrication selon l'invention, l'apport d'énergie prévu pour effectuer les soudages est réalisé de manière sensiblement localisée dans les régions respectives des protubérances métalliques au travers de la pluralité de plages de contact métalliques externes. On utile notamment des thermodes 42 et 43 montrées schématiquement à la Figure 3 (éléments chauffant pouvant être appliqués contre une surface). On notera que les thermodes peuvent être incorporée dans la presse 40 de manière à effectuer le collage et le soudage au cours d'une même étape de fabrication.

Selon une variante particulière du procédé de fabrication selon l'invention, la brasure formant les protubérances métalliques est déposée du côté de la face interne dudit support isolant par une technique de sérigraphie en couche épaisse.

Selon une autre variante particulière du procédé de fabrication selon l'invention, le film de colle 20 est agencé sur une feuille non-adhérante (non représentée sur les Figures) qui est située de l'autre côté de ladite face interne 8 après le dépôt du film de colle sur cette dernière. Ce film de colle et la feuille non-adhérante présentent des ouvertures traversant les deux et remplies de brasure, la feuille non-adhérante étant ensuite retirée pour obtenir les protubérances métalliques qui sortent des ouvertures respectives du film de colle. La brasure peut être apportée avec un certain surplus, lequel est retiré par une lame qui racle le dessus de la feuille non-adhérante. Ainsi, les ouvertures traversantes sont entièrement remplies de brasure et cette brasure présentent des surfaces planes sensiblement affleurées à la surface extérieure de la feuille non-adhérante.

Selon l'invention, les cavités individuelles ont une section transversale (dans le plan du corps de carte) dont au moins une dimension est supérieure à 0,5 mm (500 µm). En particulier, la section transversale est circulaire.

Selon la variante représentée à la Figure 4, les cavités individuelles 38a, 38c sont sensiblement remplies par le matériau métallique formant premièrement les protubérances métalliques, puis après le soudage prévu les ponts de jonction 46a, 46c entre les plages internes 34a, 34c et les plages intermédiaires 12a, 12c.

Selon une variante préférée du procédé de fabrication selon l'invention et de la carte électronique selon l'invention, les plages internes 34a, 34c sont agencées sur un support interne 32 noyé dans la matière plastique 24 du corps de carte, et ce support interne comprend ou est associé à au moins un élément de positionnement de ce support interne dans l'épaisseur du corps de carte de sorte que ces plages internes sont sensiblement situées à un niveau déterminé dans ce corps de carte. Ceci est particulièrement indiqué dans le cas de la fabrication du corps de carte au moins en partie avec une résine qui est dans un état liquide ou pâteux (mou) pour enrober les divers éléments et unités électroniques et former ce corps de carte. Le/les élément(s) de positionnement n'a/ont pas été représenté(s) sur les Figures. Il peut s'agir d'une ou plusieurs entretoises, de saillies ou de points de contact à une presse utilisée pour la fabrication du corps de carte ou à des couches solides de ce corps de carte. II(s) peut/peuvent être prévu(s) sur un ou plusieurs des éléments incorporés, en particulier sur le support interne 32. Dans le cas avec au moins une couche solide s'étendant dans la région prévue pour le logement 26, il(s) peut/peuvent initialement être agencé(s) sur cette au moins une couche solide. Cette variante préférée est utile pour une production industrielle dans laquelle les protubérances métalliques sont calibrées et présentent donc des dimensions uniformes. Grâce à cette variante, on peut effectuer pour une série de cartes électroniques donnée des cavités individuelles ayant toutes une même profondeur déterminée, car on peut assurer que les bosses de brasure sur les plages de contact internes sont alors toutes atteintes et au moins légèrement tronquées pour effectuer le soudage prévu et former les jonctions électriques prévues. Il est certes possible d'avoir des installations d'usinage capable de détecter les bosses métalliques lors de l'usinage des cavités individuelles ou, en absence de celles-ci, les plages internes elles-mêmes. Mais si la position en hauteur de ces plages internes varie passablement dans l'épaisseur du corps de carte, plus que dans des tolérances acceptables, alors le volume des cavités individuelles risquent de ne plus correspondre à celui des protubérances métalliques. Si le volume de ces dernières est inférieur à celui des cavités usinées, il sera certainement possible de réaliser correctement des cartes puisque la brasure fondue par l'apport d'énergie aura tendance à relier les plages métalliques en regard l'une de l'autre. Par contre, si le volume des protubérances déposées sur les connecteurs externes est supérieur au volume des cavités individuelles au moins pour certaines des cartes fabriquées, alors ces dernières risquent fortement de présenter des courts-circuits dus à un surplus de brasure qui s'étend hors des cavités individuelles lors du placement du connecteur externe dans son logement; ce que l'invention cherche à éviter.

Selon l'invention, on obtient de manière générale des cartes électroniques caractérisées par le fait que le logement prévu pour le connecteur externe présente une pluralité de cavités individuelles séparées par un matériau isolant formant le corps de carte et au fond desquelles apparaissent respectivement les plages internes d'une pluralité de plages de contact métalliques internes situées dans le corps de carte ou des parties métalliques agencées sur ces plages internes et en contact électrique avec celles-ci, et par le fait que les cavités individuelles sont au moins partiellement remplies par un matériau métallique qui forme des jonctions électriques entre les plages internes et des plages correspondantes du connecteur externe.

A l'aide des Figures 5 à 8, on décrira ci-après un deuxième mode de réalisation préféré de l'invention et son procédé de fabrication. Certains éléments déjà décrits et certaines étapes du procédé de fabrication déjà exposées précédemment ne seront pas exposés à nouveau en détail ci-après. Ce deuxième mode de réalisation diffère du premier essentiellement par l'agencement du connecteur externe, le procédé d'assemblage de ce connecteur externe à un corps de carte correspondant, en particulier la réalisation des jonctions électriques entre eux, étant similaire à celui déjà décrit.

Le connecteur externe 50 présente une pluralité de plages de contact externes 10a à 10f. Il comprend un support isolant 4a qui présente une pluralité d'ouvertures 52a, 52b, 52c (et une quatrième non visible sur la coupe de la Figure 6) entre sa face externe 6 et sa face interne 8. Les ouvertures de cette pluralité d'ouvertures sont respectivement fermées par les plages externes 10a, 10b, 10c et 10d, formant un sous-ensemble de la pluralité de plages de contact métalliques externes, du côté de la face externe du support isolant. De manière générale, ces ouvertures sont au moins partiellement remplies par des parties métalliques respectives 54a, 54b, 54c qui forment avec lesdites protubérances respectives 18a, 18b, 18c qui les surmontent ou les prolongent, avant l'assemblage au corps de carte du connecteur externe, des piliers métalliques 56a, 56b, 56c qui s'élèvent depuis les surfaces arrières dudit sous-ensemble de plages externes en traversant le support isolant 4a (Figure 6). Après le placement du connecteur externe dans son logement 26a du corps de carte 22a au cours duquel les protubérances 18a, 18b, 18c pénètrent dans les cavités individuelles respectives 38a, 38b, 38c et suite à l'apport d'énergie fourni à ces piliers métalliques et aux bosses métalliques tronquées 36a, 36b, 36c, pour effectuer des soudures aux plages internes 34a, 34b, 34c, des ponts de jonction métalliques 62a, 62b, 62c entre les surfaces arrières desdites plages externes et les plages internes correspondantes sont obtenus, ces ponts de jonction métalliques comprenant chacun une soudure du côté de la surface arrière de la plage externe correspondante qui assure un contact soudé à cette dernière. On obtient alors une carte électronique 60 selon l'invention telle que représentée partiellement en coupe à la Figure 7. Ces ponts de jonction métalliques définissent entièrement les jonctions électriques entre les plages internes considérées et les plages externes correspondantes.

On notera que les ouvertures 52a, 52b, 52c ont, dans une variante représentée sur les Figures, une couche métallique formant une interface d'adhésion sur leur paroi latérale, cette couche pouvant également s'étendre en périphérie des ouvertures sur la face interne du support isolant en formant des anneaux métalliques. Lors de l'apport d'énergie pour effectuer en particulier le soudage, la brasure se marie à cette couche métallique comme représenté à la Figure 7. Dans la variante représentée à cette Figure, les ouvertures dans le support isolant 4a sont sensiblement remplies par les ponts de jonction métalliques respectifs.

Dans une variante préférée, les piliers métalliques et les ponts de jonction métalliques obtenus ensuite par le procédé de fabrication selon l'invention sont constitués chacun par une brasure de sorte que la soudure du côté de la plage interne correspondante et la soudure du côté de la surface arrière de la plage externe correspondante sont formées les deux par une seule et même soudure s'étendant entre cette plage interne correspondante et cette surface arrière de la plage externe correspondante.

Selon une variante particulière, les ouvertures ont une section transversale (dans le plan général du support isolant) dont au moins une dimension est supérieure à 0,2 mm (200 µm). En particulier, la section transversale est circulaire. Selon une variante préférée, le diamètre des ouvertures est supérieur à 0,5 mm (500 µm).

Selon une variante particulière du procédé de fabrication selon l'invention, la brasure formant les protubérances métalliques est déposée du côté de la face interne du support isolant par une buse recevant la brasure d'un doseur permettant de contrôler précisément la quantité de brasure apportée dans chaque cavité individuelle au fond du logement du corps de carte. Cette variante de mise en oeuvre est particulièrement bien adaptée à la réalisation des piliers métalliques dans la fabrication du deuxième mode de réalisation d'une carte électronique selon l'invention, mais elle peut aussi être utilisée pour la fabrication du premier mode de réalisation décrit précédemment. La brasure déposée peut l'être par exemple sous forme de pâte, sous forme de métal en fusion qui durcit suite au dépôt ou par l'apport d'éléments préformés. Une étape de mise en forme des protubérances peut être prévue de manière à obtenir une forme donnée et des dimensions sensiblement identiques pour toutes les protubérances. On notera que les variantes décrites précédemment pour réaliser les protubérances métalliques dans le cadre du premier mode de réalisation peuvent aussi être utilisées pour réaliser les piliers métalliques du deuxième mode de réalisation. Dans le cas de l'utilisation d'une technique de sérigraphie, on veillera à ce que les piliers métalliques aient un diamètre inférieur à celui des ouvertures 52a, 52b, 52c pour qu'ils ne présentent pas une couronne faisant saillie à leur extrémité libre.

A la Figure 8 est représenté partiellement en coupe un connecteur externe 50a qui est une variante du connecteur 50 de la Figure 6. Ce connecteur se distingue par le fait que les piliers métalliques 56a, 56b, sont formés par des parties métalliques 54a, 54b constituées de brasure ayant déjà été une fois fondue et durcie pour former un métal plein, sans air ou/et liquide (solvant). Sur ces parties métalliques sont agencées les protubérances métalliques 18a, 18b, ces dernières étant constituées par une brasure sous forme de pâte ayant toutefois été séchée après son dépôt du côté de la face interne 8 du support isolant 4a. Ces protubérances sont déposées par une buse et présentent une forme sensiblement arrondie. Comme les cavités individuelles du corps de carte sont cylindriques, il est prévu que les protubérances présentent initialement, ayant l'assemblage, une hauteur supérieure à la profondeur des cavités individuelles. Lors de l'introduction des protubérances dans les cavités respectives, les protubérances sont écrasées et déformées pour remplir au moins partiellement les cavités respectives. Après apport d'énergie et soudage des jonctions électriques, on obtient une carte électronique 60 telle que représentée à la Figure 7. On notera que les brasures des parties métalliques et des protubérances peuvent être différentes ou du même matériau / alliage métallique.

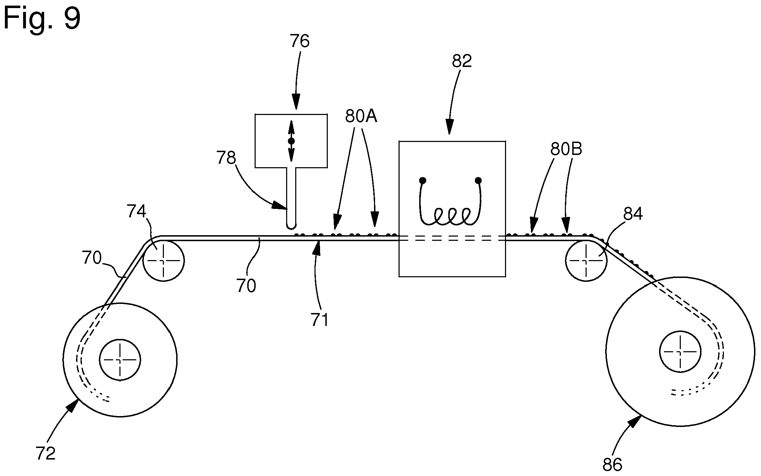

A la Figure 9 est représentée la fabrication d'une pluralité de connecteurs externes en bande. Les supports isolants de la pluralité de connecteurs sont initialement formés par une bande 70 qui comprend sur une face 71 des plages de contact métalliques (non représentées) et de l'autre côté soit des plages de contact intermédiaires reliées électriquement chacune à une des plages de contact métalliques externes, soit des ouvertures traversant le support isolant jusqu'à des surfaces arrières respectives d'au moins un sous-ensemble desdites plages de contact métalliques. La bande est premièrement enroulée sur une première bobine 72. Elle est ensuite déroulée progressivement et après avoir passé un premier rouleau 74, elle défile sous un distributeur de brasure 76 comprenant une buse ou une aiguille 78 par laquelle des gouttes de brasure sont déposées sur chacune desdites plages de contact intermédiaires ou dans chacune desdites ouvertures. Cette opération est réalisée avec précision, le distributeur étant prévu mobile au moins selon une direction transversale à la direction de défilement de la bande 70 dans un plan parallèle à cette dernière. Ce distributeur est agencé pour déposer des doses précises de brasure. Selon l'invention, la brasure déposée définit une pluralité de protubérances métalliques 80A. Dans le cas présent, selon une variante de l'invention, la brasure est déposée sous forme de pâte.

La bande 70 avec les protubérances 80A formées d'une pâte de brasure passe alors dans un four 82 qui sert à sécher et à durcir la brasure. A la sortie du four, on a donc des protubérances 80B formées de brasure durcie. Le four est par exemple un four à air chaud ou à UV. Dans une variante particulière, l'apport de chaleur est réalisé de manière localisée aux protubérances par des diodes optiques. Une fois que la bande à traverser le four, elle est enroulée sur une deuxième bobine 86 après avoir passé sur un deuxième rouleau 84. Ceci permet de stocker aisément une pluralité de connecteurs externes selon l'invention, avant de les utiliser dans la fabrication d'une pluralité de cartes électroniques au cours de laquelle la bande 70 avec les protubérances métalliques 80B est déroulée progressivement de la bobine de stockage 86, les connecteurs externes étant alors découpés dans la bande pour former des connecteurs individuels qui sont ensuite apportés respectivement dans des logements de la pluralité de cartes.

On notera que, dans une variante, au lieu du distributeur de brasure il est prévu de réaliser les protubérances par des éléments préformés qui sont apportés et mis en place par une installation automatique sur la pluralité de connecteurs en bande.

## Revendications

1. Procédé de fabrication d'une carte électronique formée par :
- un connecteur externe (2; 50; 50a) comprenant un support isolant (4; 4a), définissant une face externe et une face interne opposées l'une à l'autre, et une pluralité de plages de contact métalliques externes qui sont agencées sur ladite face externe (6) de ce support isolant;
- un corps de carte (22; 22a) présentant un logement (26; 26a) pour ledit connecteur externe;
- une unité électronique et/ou une antenne incorporée(s) dans ledit corps de carte et reliée(s) électriquement à ou présentant une pluralité de plages métalliques internes (34a, 34b, 34c) qui sont agencées sous ledit logement ;ce procédé comprenant une étape d'usinage de cavités individuelles (38a, 38b, 38c) dans ledit corps de carte jusqu'à ce que les plages métalliques internes soient atteintes ou jusqu'à ce que des parties métalliques (36a, 36b, 36c), agencées sur ces plages métalliques internes et en contact électrique avec celles-ci, soient atteintes, ces parties métalliques ou les plages métalliques internes pouvant être partiellement usinées ;
ce procédé de fabrication étant **caractérisé en ce que** lesdites cavités individuelles ont une section transversale dont au moins une dimension est supérieure à 0,5 mm (500 µm), et par les étapes suivantes :
- formation dudit connecteur externe avec une pluralité de protubérances métalliques (18a, 18b, 18c) situées du côté de ladite face interne (8) dudit support isolant et respectivement reliées électriquement à au moins un sous-ensemble de ladite pluralité de plages de contact métalliques externes et/ou à des plages de contact associées à une deuxième unité électronique (14) qui est agencée sur la face interne du support isolant et destinée à être située dans ledit logement, ces protubérances métalliques étant agencées de manière à être respectivement en face desdites cavités individuelles lors du placement du connecteur externe dans ledit logement et configurées pour pouvoir être introduites dans ces cavités individuelles de manière à les remplir au moins en majeure partie ;
- suite à ladite formation dudit connecteur externe et audit usinage de cavités individuelles dans le corps de carte, placement de ce connecteur externe dans le logement du corps de carte avec lesdites protubérances métalliques introduites dans les cavités individuelles respectives, le volume initial de chaque protubérance étant prévu de manière que le volume de cette protubérance, une fois le connecteur en place dans son logement, soit sensiblement égal ou inférieur au volume de la cavité individuelle correspondante ;
- apport d'énergie transmise au moins partiellement auxdites protubérances métalliques pour effectuer un soudage au moins du côté desdites plages métalliques internes et former des contacts soudés entre celles-ci et le connecteur externe, des jonctions électriques étant ainsi obtenues entre lesdites plages métalliques internes et ledit au moins un sous-ensemble de la pluralité de plages de contact métalliques externes et/ou lesdites plages de contact associées à ladite deuxième unité électronique.

2. Procédé de fabrication selon la revendication 1, **caractérisé en ce que** lesdites cavités individuelles sont circulaires et ont un diamètre supérieur à 0,5 mm (500 µm).

3. Procédé de fabrication selon la revendication 1 ou 2, **caractérisé en ce qu'**une pluralité de plages de contact intermédiaires (12a, 12c) sont agencées sur ladite face interne dudit connecteur externe et sont reliées électriquement audit au moins un sous-ensemble de ladite pluralité de plages de contact métalliques externes et/ou auxdites plages de contact associées à ladite deuxième unité électronique, ces plages de contact intermédiaires étant respectivement situées sous lesdites protubérances métalliques, et **en ce que** ces protubérances métalliques sont constituées par une brasure qui forme, suite audit apport d'énergie, une soudure (46a, 46c) entre chacune desdites plages internes et une plage de contact intermédiaire correspondante parmi lesdites plages de contact intermédiaires.

4. Procédé de fabrication selon la revendication 1 ou 2, **caractérisé en ce que** ledit support isolant (4a) présente une pluralité d'ouvertures (52a, 52b, 52c) entre sa face externe et sa face interne, les ouvertures de cette pluralité d'ouvertures étant respectivement fermées (10a, 10b, 10c) par les plages externes dudit au moins un sous-ensemble de ladite pluralité de plages de contact métalliques externes du côté de la face externe du support isolant, **en ce que** lesdites ouvertures sont au moins partiellement remplies par des parties métalliques respectives (54a, 54b, 54c), et **en ce que** ces parties métalliques forment avec les protubérances métalliques respectives (18a, 18b, 18c) qui les surmontent ou les prolongent, suite audit apport d'énergie qui est fourni aux protubérances métalliques respectives et également aux parties métalliques, des ponts de jonction métalliques (62a, 62b, 62c) entre les surfaces arrières des plages externes respectives et les plages internes correspondantes, ces ponts de jonction métalliques comprenant chacun une soudure du côté de la surface arrière de la plage externe correspondante qui assure un contact soudé à cette dernière.

5. Procédé de fabrication selon la revendication 4, **caractérisé en ce que** lesdites ouvertures sont circulaires et ont un diamètre supérieur à 0,5 mm (500 µm).

6. Procédé de fabrication selon la revendication 5, **caractérisé en ce que** chacun desdits ponts de jonction métalliques est constitué substantiellement par une brasure qui est fondue par ledit apport d'énergie de manière à former une seule et même soudure (62a, 62b, 62c) entre une plage interne et la surface arrière de la plage externe correspondante.

7. Procédé de fabrication selon l'une des revendications 3 à 6, **caractérisé en ce que** ladite brasure formant lesdites protubérances métalliques est déposée du côté de la face arrière dudit support isolant par une technique de sérigraphie en couche épaisse.

8. Procédé de fabrication selon l'une des revendications 3 à 6, **caractérisé en ce que** ladite brasure formant lesdites protubérances métalliques est déposée du côté de la face arrière dudit support isolant par une buse ou aiguille recevant ladite brasure d'un doseur permettant de contrôler précisément la quantité de brasure apportée.

9. Procédé de fabrication selon l'une des revendications 3 à 6, **caractérisé en ce qu'**un film de colle (20) est déposé sur la face interne (8) dudit support isolant, ce film de colle étant prévu pour coller le connecteur externe contre le fond dudit logement après son apport dans ce dernier, ce film de colle étant agencé sur une feuille non-adhérante qui est située de l'autre côté de ladite face interne après le dépôt du film de colle, ce dernier et la feuille non-adhérante présentant des ouvertures traversant les deux, et **en ce que** ces ouvertures sont remplies de brasure, la feuille non-adhérante étant ensuite retirée pour obtenir lesdites protubérances métalliques qui sortent des ouvertures respectives dudit film de colle.

10. Procédé de fabrication selon l'une des revendications 3 à 6, **caractérisé en ce que** lesdites protubérances métalliques sont préformées et déposées du côté de la face arrière dudit support isolant par une installation automatique.

11. Procédé de fabrication selon l'une des revendications 3 à 9, **caractérisé en ce que** ladite brasure constituant lesdites protubérances métalliques est apportée sous forme de pâte et est ensuite durcie avant le placement du connecteur externe dans ledit logement.

12. Procédé de fabrication selon l'une des revendications 1 à 11, **caractérisé en ce que** lesdites protubérances métalliques ont des dimensions initiales prévues de manière que, suite au placement du connecteur externe dans ledit logement, ces protubérances remplissent en majeure partie les cavités individuelles respectives (38a, 38b, 38c).

13. Procédé de fabrication selon l'une des revendications 1 à 8, **caractérisé en ce qu'**il est prévu de déposer un film de colle (20) sur la face interne dudit support isolant, ce film de colle servant à coller le connecteur externe contre le fond dudit logement et présentant des ouvertures desquelles sortent lesdites protubérances métalliques.

14. Procédé de fabrication selon l'une des revendications 1 à 13, **caractérisé en ce que** ledit apport d'énergie est réalisé de manière sensiblement localisée dans les régions respectives desdites protubérances métalliques au travers de ladite pluralité de plages de contact métalliques externes.

## Patentansprüche

1. Verfahren zum Herstellen einer elektronischen Karte, die gebildet ist durch:
einen äußeren Verbinder (2; 50; 50a), der einen isolierenden Träger (4; 4a), der eine äußere Fläche und eine innere Fläche, die einander gegenüberliegen, definiert, und mehrere äußere metallische Kontaktbereiche, die auf der äußeren Fläche (6) dieses isolierenden Trägers angeordnet sind, umfasst;
- einen Kartenkörper (22; 22a), der einen Aufnahmeraum (26; 26a) für den äußeren Verbinder aufweist;
- eine elektronische Einheit und/oder eine Antenne, die in den Kartenkörper eingebaut sind/ist und die mit mehreren inneren metallischen Bereichen (34a, 34b, 34c), die unter dem Aufnahmeraum angeordnet sind, elektrisch verbunden sind/ist oder diese aufweisen/aufweist; wobei dieses Verfahren einen Schritt des Bearbeitens einzelner Hohlräume (38a, 38b, 38c) in dem Kartenkörper umfasst, bis die inneren metallischen Bereiche erreicht werden oder bis metallische Teile (36a, 36b, 36c), die auf diesen inneren metallischen Bereichen angeordnet sind und damit in elektrischem Kontakt sind, erreicht werden, wobei diese metallischen Teile oder die inneren metallischen Bereiche teilweise bearbeitet werden können;
wobei dieses Herstellungsverfahren **dadurch gekennzeichnet ist, dass** die einzelnen Hohlräume einen Querschnitt haben, von dem wenigstens eine Abmessung größer als 0,5 mm (500 µm) ist, und durch die folgenden Schritte:
- Bilden des äußeren Verbinders mit mehreren metallischen Erhebungen (18a, 18b, 18c), die sich auf Seiten der inneren Fläche (8) des isolierenden Trägers befinden und jeweils verbunden sind mit wenigstens einer Teilmenge der mehreren äußeren metallischen Kontaktbereiche und/oder mit den Kontaktbereichen, die einer zweiten elektronischen Einheit (14) zugeordnet sind, die auf der inneren Fläche des isolierenden Trägers angeordnet ist, und dazu bestimmt sind, in dem Hohlraum zu liegen, wobei diese metallischen Erhebungen in der Weise angeordnet sind, dass sie sich jeweils gegenüber den einzelnen Hohlräumen befinden, wenn der äußere Verbinder in dem Aufnahmeraum angeordnet wird, und ausgebildet sind, um in diese einzelnen Hohlräume eingeführt werden zu können, derart, dass sie wenigstens den Hauptteil hiervon ausfüllen;
- nach dem Bilden des äußeren Verbinders und nach dem Bearbeiten der einzelnen Hohlräume in dem Kartenkörper, Anordnen dieses äußeren Verbinders in dem Aufnahmeraum des Kartenkörpers mit den in die jeweiligen einzelnen Hohlräume eingeführten Erhebungen, wobei das anfängliche Volumen jeder Erhebung so vorgesehen ist, dass das Volumen dieser Erhebung, sobald der Verbinder in seinem Aufnahmeraum angeordnet ist, im Wesentlichen gleich oder kleiner als das Volumen des entsprechenden einzelnen Hohlraums ist;
- Eintragen von Energie, die wenigstens teilweise an die metallischen Erhebungen übertragen wird, um ein Verlöten wenigstens auf Seiten der inneren metallischen Bereiche zu bewirken und um Lötkontakte zwischen ihnen und dem äußeren Verbinder zu bilden, wodurch elektrische Verbindungen zwischen den inneren metallischen Bereichen und der wenigstens einen Teilmenge der mehreren äußeren metallischen Kontaktbereiche und/oder den Kontaktbereichen, die der zweiten elektronischen Einheit zugeordnet sind, gebildet werden.

2. Herstellungsverfahren nach Anspruch 1, **dadurch gekennzeichnet, dass** die einzelnen Hohlräume kreisförmig sind und einen Durchmesser von mehr als 0,5 mm (500 µm) besitzen.

3. Herstellungsverfahren nach Anspruch 1 oder 2, **dadurch gekennzeichnet, dass** mehrere Zwischenkontaktbereiche (12a, 12c) auf der inneren Fläche des äußeren Verbinders angeordnet sind und mit der wenigstens einen Teilmenge der mehreren äußeren metallischen Kontaktbereiche und/oder mit den Kontaktbereichen, die der zweiten elektronischen Einheit zugeordnet sind, elektrisch verbunden sind, wobei sich diese Zwischenkontaktbereiche jeweils unter den metallischen Erhebungen befinden, und dass diese metallischen Erhebungen durch ein Lötmittel gebildet sind, das nach dem Energieeintrag eine Verlötung (46a, 46c) zwischen jedem der inneren Bereiche und einen entsprechenden Zwischenkontaktbereich unter den Zwischenkontaktbereichen bildet.

4. Herstellungsverfahren nach Anspruch 1 oder 2, **dadurch gekennzeichnet, dass** der isolierende Träger (4a) zwischen seiner äußeren Fläche und seiner inneren Fläche mehrere Öffnungen (52a, 52b, 52c) aufweist, wobei die Öffnungen dieser mehreren Öffnungen jeweils durch die äußeren Bereiche der wenigstens einen Teilmenge der mehreren äußeren metallischen Kontaktbereiche auf Seiten der äußeren Fläche des isolierenden Trägers verschlossen sind (10a, 10b, 10c), dass die Öffnungen wenigstens teilweise durch die jeweiligen metallischen Teile (54a, 54b, 54c) ausgefüllt sind und dass diese metallischen Teile mit den jeweiligen metallischen Erhebungen (18a, 18b, 18c), die sie überragen oder verlängern, nach dem Eintrag von Energie, die den jeweiligen metallischen Erhebungen und außerdem den metallischen Teilen zugeführt wird, metallische Verbindungsbrücken (62a, 62b, 62c) zwischen den hinteren Oberflächen der jeweiligen äußeren Bereiche und den entsprechenden inneren Bereichen bilden, wobei diese metallischen Verbindungsbrücken jeweils eine Verlötung auf Seiten der hinteren Oberfläche des entsprechenden äußeren Bereichs aufweisen, die einen Lötkontakt mit diesen Letzteren gewährleistet.

5. Herstellungsverfahren nach Anspruch 4, **dadurch gekennzeichnet, dass** die Öffnungen kreisförmig sind und einen Durchmesser von mehr als 0,5 mm (500 µm) besitzen.

6. Herstellungsverfahren nach Anspruch 5, **dadurch gekennzeichnet, dass** jede der metallischen Verbindungsbrücken im Wesentlichen durch ein Lötmittel gebildet ist, das durch den Energieeintrag geschmolzen wird, derart, dass ein und dieselbe Verlötung (62a, 62b, 62c) zwischen einem inneren Bereich und der hinteren Oberfläche des entsprechenden äußeren Bereichs gebildet wird.

7. Herstellungsverfahren nach einem der Ansprüche 3 bis 6, **dadurch gekennzeichnet, dass** das Lötmittel, das die metallischen Erhebungen bildet, auf Seiten der hinteren Fläche des isolierenden Trägers durch eine Dickschicht-Siebdrucktechnik abgelagert wird.

8. Herstellungsverfahren nach einem der Ansprüche 3 bis 6, **dadurch gekennzeichnet, dass** das Lötmittel, das die metallischen Erhebungen bildet, auf Seiten der hinteren Fläche des isolierenden Trägers durch eine Düse oder Nadel, die das Lötmittel von einer Dosiervorrichtung aufnimmt, die ermöglicht, die eingebrachte Lötmittelmenge präzise zu steuern, aufgebracht wird.

9. Herstellungsverfahren nach einem der Ansprüche 3 bis 6, **dadurch gekennzeichnet, dass** auf die innere Fläche (8) des isolierenden Trägers ein Klebefilm (20) aufgebracht wird, wobei dieser Klebefilm dazu vorgesehen ist, den äußeren Verbinder an den Boden des Aufnahmeraums zu kleben, nachdem er in diesen Letzteren eingebracht worden ist, wobei dieser Klebefilm auf einer nicht klebenden Folie angebracht ist, die sich auf der anderen Seite der inneren Fläche befindet, nachdem der Klebefilm aufgebracht worden ist, wobei dieser Letztere und die nicht klebende Folie Öffnungen aufweisen, die durch sie beide verlaufen, und dass diese Öffnungen mit Lötmittel gefüllt sind, wobei die nicht klebende Folie anschließend abgezogen wird, um die metallischen Erhebungen zu erhalten, die aus den jeweiligen Öffnungen des Klebefilms herausragen.

10. Herstellungsverfahren nach einem der Ansprüche 3 bis 6, **dadurch gekennzeichnet, dass** die metallischen Erhebungen vorgeformt und auf Seiten der hinteren Fläche des isolierenden Trägers durch eine automatische Anlage abgelagert werden.

11. Herstellungsverfahren nach einem der Ansprüche 3 bis 9, **dadurch gekennzeichnet, dass** das Lötmittel, das die metallischen Erhebungen bildet, in Form einer Paste aufgebracht wird und anschließend gehärtet wird, bevor der äußere Verbinder in dem Aufnahmeraum angeordnet wird.

12. Herstellungsverfahren nach einem der Ansprüche 1 bis 11, **dadurch gekennzeichnet, dass** die metallischen Erhebungen anfängliche Abmessungen besitzen, die in der Weise vorgesehen sind, dass nach dem Anordnen des äußeren Verbinders in dem Aufnahmeraum diese Erhebungen den Hauptteil der jeweiligen einzelnen Hohlräume (38a, 38b, 38c) ausfüllen.

13. Herstellungsverfahren nach einem der Ansprüche 1 bis 8, **dadurch gekennzeichnet, dass** vorgesehen ist, einen Klebefilm (20) auf die innere Fläche des isolierenden Trägers aufzubringen, wobei dieser Klebefilm dazu dient, den äußeren Verbinder an den Boden des Aufnahmeraums zu kleben, und Öffnungen aufweist, aus denen die metallischen Erhebungen herausragen.

14. Herstellungsverfahren nach einem der Ansprüche 1 bis 13, **dadurch gekennzeichnet, dass** der Energieeintrag im Wesentlichen räumlich begrenzt in den jeweiligen Bereichen der metallischen Erhebungen durch die mehreren äußeren metallischen Kontaktbereiche hindurch erfolgt.

## Claims

1. Process for the production of an electronic card formed by:
- an external connector (2; 50; 50a) comprising an insulating support (4; 4a) that defines an outside face and an inside face opposite one another and a plurality of external metal contact pads, which are arranged on the outside face (6) of this insulating support;
- a card body (22; 22a) having a cavity (26; 26a) for said external connector;
- an electronic unit and/or an antenna incorporated in the card body and electrically connected to or having a plurality of internal metal pads (34a, 34b, 34c) arranged under said cavity;
wherein this process comprises a step of machining individual cavities (38a, 38b, 38c) in said card body until the internal metal pads are reached or until metal parts (36a, 36b, 36c) arranged on these internal metal pads and in electrical contact therewith are reached, and these metal parts or the internal metal pads can be partially machined;
wherein this production process is **characterised in that** said individual cavities have a cross-section in which at least one dimension is greater than 0.5 mm (500µm) and by the following steps:
- forming said external connector with a plurality of metal projections (18a, 18b, 18c) located on the side of said inside face (8) of said insulating support and respectively connected electrically to at least one subassembly of said plurality of external metal contact pads and/or to contact pads linked to a second electronic unit (14), which is arranged on the inside face of the insulating support and intended to be located in said cavity, wherein these metal projections are arranged in order to respectively face said individual cavities during the placement of the external connector in said cavity and configured to be capable of being inserted into these individual cavities in order to fill them at least for the most part;
- subsequent to said forming of said external connector and said machining of individual cavities in the card body, placing this external connector in the cavity of the card body, with said metal projections inserted into the respective individual cavities, and the initial volume of each projection is provided such that, once the connector is in place in its cavity, the volume of this projection is substantially equal to or smaller than the volume of the corresponding individual cavity;
- supplying energy at least partially to the metal projections to perform soldering at least on the side of said internal metal pads and form soldered contacts between these and the external connector, wherein electrical junctions are thus obtained between said internal metal pads and said at least one subassembly of the plurality of external metal contact pads and/or said contact pads linked to said second electronic unit.

2. Production process according to claim 1, **characterised in that** said individual cavities are circular and have a diameter larger than 0.5 mm (500 µm).

3. Production process according to claim 1 or 2, **characterised in that** a plurality of intermediate contact pads (12a, 12c) are arranged on said inside face of said external connector and electrically connected to said at least one subassembly of said plurality of external contact pads and/or to said contact pads linked to said second electronic unit, wherein these intermediate contact pads are respectively located under said metal projections, and **in that** these metal projections are formed by a solder material, which subsequent to said supply of energy forms a solder joint (46a, 46c) between each of said internal pads and a corresponding intermediate contact pad of said intermediate contact pads.

4. Production process according to claim 1 or 2, **characterised in that** said insulating support (4a) has a plurality of apertures (52a, 52b, 52c) between its outside face and its inside face, wherein the apertures of this plurality of apertures are respectively closed (10a, 10b, 10c) by the external pads of said at least one subassembly of said plurality of external metal contact pads on the side of the outside face of the insulating support; **in that** said apertures are at least partially filled by respective metal parts (54a, 54b, 54c); and **in that** with the respective metal projections (18a, 18b, 18c) that surmount them or extend them and after the supply of energy that is supplied to the respective metal projections and also to the metal parts, these metal parts form metal connecting bridges (62a, 62b, 62c) between the rear surfaces of the respective external pads and the corresponding internal pads, wherein these metal connecting bridges each comprise a solder joint on the side of the rear surface of the corresponding external pad that assures a soldered contact to the latter.

5. Production process according to claim 4, **characterised in that** said apertures are circular and have a diameter larger than 0.5 mm (500 µm).

6. Production process according to claim 5, **characterised in that** each of said metal connecting bridges is formed substantially by a solder material that is melted by said supply of energy in order to form the same single solder joint (62a, 62b, 62c) between an internal pad and the rear surface of the corresponding external pad.

7. Production process according to any of claims 3 to 6, **characterised in that** said solder material forming said metal projections is deposited on the side of the rear face of said insulating support using a thick film screen-printing process.

8. Production process according to any of claims 3 to 6, **characterised in that** said solder material forming said metal projections is deposited on the side of the rear face of said insulating support by a nozzle or needle that receives the solder material from a metering device allowing the quantity of solder material to be controlled precisely.

9. Production process according to any of claims 3 to 6, **characterised in that** an adhesive film (20) is deposited on the inside face (8) of said insulating support, wherein this adhesive film is provided to glue the external connector to the base of said cavity after being applied to the latter, and this adhesive film is arranged on a non-stick sheet, which is located on the other side of said inside face after deposition of the adhesive film, wherein this film and the non-stick sheet have apertures traversing both; and **in that** these apertures are filled with solder material, and the non-stick sheet is then removed to obtain said metal projections, which exit from the respective apertures of said adhesive film.

10. Production process according to any of claims 3 to 6, **characterised in that** said metal projections are preformed and placed on the side of the rear face of said insulating support by an automatic installation.

11. Production process according to any of claims 3 to 9, **characterised in that** said solder material forming said metal projections is applied in paste form and is then hardened before placement of the external connector in said cavity.

12. Production process according to any of claims 1 to 11, **characterised in that** the initial dimensions provided for said metal projections are such that, subsequent to the placement of the external connector in said cavity, these projections for the most part fill the respective individual cavities (38a, 38b, 38c).

13. Production process according to any of claims 1 to 8, **characterised in that** it is provided to deposit an adhesive film (20) on the inside face of said insulating support, wherein this adhesive film serves to glue the external connector to the base of said cavity and has apertures, from which said metal projections exit.

14. Production process according to any of claims 1 to 13, **characterised in that** said supply of energy is achieved in a substantially localised manner in the respective regions of said metal projections through said plurality of external metal contact pads.
